# EUROPEAN PATENT SPECIFICATION

(11) **EP 0 782 255 B1**
(45) Date of publication and mention of the grant of the patent: **27.03.2002**
(21) Application number: 96120642.2
(22) Date of filing: 20.12.1996
(51) Int. Cl.: H03H 9/64

(54) **Longitudinal coupling type surface acoustic wave resonator filter**
Akustisches Oberflächenwellenresonatorfilter mit longitudinaler Kopplung
Filtre résonateur à ondes acoustiques de surface à couplage longitudinal

(30) Priority: 28.12.1995 JP 34358595
(43) Date of publication of application: 02.07.1997
(73) Proprietor: MURATA MANUFACTURING CO., LTD., Nagaokakyo-shi Kyoto-fu 226 (JP)
(72) Inventor: Shimoe, Kazunobu, Nagaokakyo-shi, Kyoto-fu (JP)
(74) Representative: Laufhütte, Dieter, Dr.-Ing.

(56) References cited:
- EP-A- 0 401 737
- EP-A- 0 569 977
- US-A- 5 392 013
- PATENT ABSTRACTS OF JAPAN vol. 004, no. 165 (E-034), 15 November 1980 & JP 55 115712 A (MATSUSHITA ELECTRIC IND CO LTD), 5 September 1980,

## Description

### BACKGROUND OF THE INVENTION

### 1. Field of the Invention

The present invention relates to longitudinal coupling type surface acoustic wave resonator filters and, more particularly, to a longitudinal coupling type surface acoustic wave resonator filter in which the electrode structure is improved so that the selectivity becomes higher.

### 2. Description of the Related Art

Recently, surface acoustic wave (SAW) filters have been put to use as bandpass filters for various communication apparatuses. There is a need for setting a suitable pass band width and for achieving high selectivity as characteristics of bandpass filters. Correspondingly, with respect to, for example, SAW filters used in radiofrequency (RF) stages, there is also a need for setting a pass band width as desired and for achieving high selectivity.

In particular, in the case of SAW filers for RF stages in cordless telephone sets in accordance with the CT-1, CT-1+ and CT-2 standards, it is important to set a sufficiently large attenuation at points ± 20 MHz and ± 40 MHz apart from a center frequency, although the desired attenuation varies depending upon intermediate frequency (IF) filters used in the telephone sets. Thus, filters having higher selectivity are required. Also with respect to IF filters, characteristics of selectivity between adjacent channels are important.

On the other hand, it is known that, among SAW filters, those using SAW resonators are particularly effective in reducing the loss, in increasing the out-of-band attenuation and in reducing the size. For example, a filter has been proposed which consists of longitudinal coupling type SAW resonator filters in a multi-stage connection. Each SAW resonator filter is formed by arranging three sets of interdigital (ID) electrodes at equal intervals in a surface wave propagation direction on a piezoelectric monocrystalline substrate formed of a 36° Y-cut X-propagation LiTaO₃ monocrystal or the like and by providing reflector electrodes on the opposite sides of the ID electrode arrangement region in the surface wave propagation direction. The filter thus arranged can operate with a smaller loss and can be smaller in size.

EP 0 569 977 discloses a surface wave filter including a piezoelectric substrate and three sets of interdigital electrodes including a plurality of electrode fingers of comb shape. On opposite sides of the interdigital electrodes reflectors are disposed. The respective distances between the interdigital electrodes are equal. A large passband width can be obtained at small ripples with an increase of the attenuation amount outside the band region by differentiating the number of pairs of electrode fingers of the second and third interdigital electrodes from the number of pairs of electrode fingers of the first interdigital electrode.

In the above-described conventional longitudinal coupling type SAW resonator filter, however, the attenuation in a stop band higher than the pass band cannot be sufficiently increased.

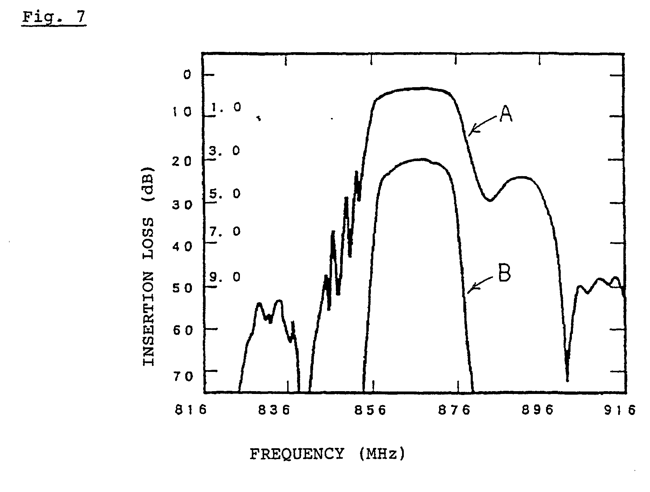

Fig. 7 shows an example of an insertion loss-frequency characteristic of a filter consisting of the above-described conventional longitudinal coupling type SAW resonator filters in two-stage connection. In Fig. 7, an essential portion of the characteristic represented by the solid line A is replotted as represented by the solid line B by enlarging the scale of insertion loss, that is, using the scale on the right-hand side of the ordinate.

The characteristic curve shown in Fig. 7, representing the characteristic of the structure formed of the conventional longitudinal coupling type SAW resonator filters in a multi-stage connection having a pass band set at 864 to 868 MHz, has a rise at a frequency higher than the pass band due to a response of the ID electrodes (as indicated by arrow C in Fig. 7), which shows that the attenuation in the range of about 886 to 906 MHz is not sufficiently large.

JP 3112210 discloses a surface acoustic wave device having a plurality of interdigital electrodes wherein the respective distance between the first and second electrodes is (n/2)λ (n: integer; λ: wave-length of surface acoustic wave in center frequency of filter), whereas the respective distance between the first and third electrodes is (n/2)λ + Nin, wherein Nin is the number of pairs of input electrodes. By this way the contribution of triple transit echo is reduced and the shoulder characteristic of the filter is improved.

The above-mentioned response of the ID electrodes is caused by internal reflection in the ID electrodes. Therefore, the level of the response depends upon the film thickness and line width of the electrode. For this reason, the method of increasing the film thickness of electrode fingers or reducing the line width in a manufacturing process to set the desired attenuation in the above-mentioned range has necessarily been used as a method for reducing the level of undesirable response of the IC electrodes.

However, if the film thickness of the electrode fingers is increased, the attenuation of surface waves propagating in the ID electrodes is increased, resulting in an increase in insertion loss. If the line width of the electrode fingers is increased, the electrical resistance through each electrode finger is increased, also resulting in an increase in insertion loss.

As conventional design methods for increasing the selectivity of SAW filters, a new phase weighting method (Shingaku Giho US81-22) and a method of forming a split structure in a part of ID electrodes to limit internal reflection in the ID electrodes are known.

Of these methods, however, the former necessitates a troublesome operation for designing weighted ID electrodes and also necessitates an increased number of electrode fingers to be thinned out. Therefore, it entails the problem of an increase in impedance or an increase in the length of the ID electrodes.

The latter method uses a split electrode having electrode fingers the width of which is half the width of the ordinary electrode fingers, i.e., solid electrodes. Therefore, it necessitates advanced processing techniques such as dry etching techniques if it is used for filters of 800 MHz or higher bands. It also entails the problem of a reduction in yield mainly because it is difficult to control the width of electrode fingers of each ID electrode in the mixed arrangement of the solid electrodes and the split electrodes.

### SUMMARY OF THE INVENTION

In view of these circumstances, an object of the present invention is to provide a longitudinal coupling type SAW resonator filter capable of obtaining high selectivity without increasing the insertion loss and capable of being mass-produced with improved facility.

To achieve this object there is provided a multiple-electrode-set longitudinal coupling type surface acoustic wave resonator filter comprising a piezoelectric substrate made of a piezoelectric material or a substrate having a piezoelectric thin film formed thereon, and first to Xth (X: an integer equal to or larger than 3) sets of interdigital electrodes formed on the piezoelectric substrate or in contact with the piezoelectric thin film. The second to Xth sets of interdigital electrodes are formed along a direction of propagation of surface waves excited and received by the first set of interdigital electrodes. The filter also comprises first and second reflectors formed on the opposite sides in the surface wave propagation direction of the area in which the first to Xth sets of interdigital electrodes are provided. Each of the sets of interdigital electrodes is formed of a pair of comb electrodes each having at least one electrode finger. If the center distances between adjacent-end electrode fingers of adjacent pairs of the interdigital electrodes are L₁, L₂, ... L_{X-1}, the center distances satisfy equations (4) and (5):${\text{L}}_{\text{S}} {\text{= L}}_{\text{1}} {\text{= L}}_{\text{3}} {\text{= L}}_{\text{5}} \text{...}$${\text{L}}_{\text{A}} {\text{= L}}_{\text{2}} {\text{= L}}_{\text{4}} {\text{= L}}_{\text{6}} \text{...}$

If the wavelength of surface waves determined by the electrode finger pitch of the reflectors is λ, the center distances L_{S} and L_{A} satisfy inequalities (6) and (7):${\text{0 + nλ < L}}_{\text{S}} \text{< 1/2λ + nλ}$ (n: integer)${\text{1/2λ + mλ < L}}_{\text{A}} \text{< (m + 1)λ}$ (m: integer)
or inequalities (8) and (9):${\text{1/2λ + nλ < L}}_{\text{S}} \text{< (n + 1)λ}$ (n: integer)${\text{0 + mλ < L}}_{\text{A}} \text{< 1/2λ + mλ}$ (m: integer), and
the center distances Ls and L_{A} satisfy an inequality (10):${\text{L}}_{\text{S}} {\text{≠ L}}_{\text{A}} \text{- 1/2λ + kλ}$ (k: integer).

Thus, a longitudinal coupling type SAW resonator filter capable of reliably setting the desired band width and having improved selectivity can be provided.

If for example X = 3 the second and third sets of ID electrodes are formed on the opposite sides of the first set of ID electrodes in a direction of propagation of surface waves excited and received by the first set of ID electrodes. A center distance L₁ between centers of the electrode finger of the first set of ID electrodes and the electrode finger of the second set of ID electrodes adjacent to each other and a center distance L₂ between centers of the electrode finger of the first set of ID electrodes and the electrode finger of the third set of ID electrodes adjacent to each other are set to different values.

In the longitudinal coupling type SAW resonator filter of the present invention having the first to Xth sets of ID electrodes formed on the substrate made of a piezoelectric material or the substrate having a piezoelectric film formed thereon and the first and second reflectors provided on the opposite side of the area in which the first to third ID electrode sets are provided, the center distances L_{S} and L_{A} are set to different values A high-selectivity characteristic can be achieved by using two resonant modes determined by the center distances L_{S} and L_{A}. The reason for this effect will become apparent from the following detailed description of preferred embodiments of the present invention.

According to the present invention, a piezoelectric monocrystal of LiTaO₃, LiNbO₃, quartz or the like or a lead titanate-zirconate piezoelectric ceramic may be used as the material for forming the above-mentioned piezoelectric substrate. On the other hand, as the above-mentioned substrate having a piezoelectric thin film formed thereon, a substrate may be provided by forming a piezoelectric thin film of ZnO, AIN or the like on a surface of an insulating member made of an insulating ceramic such as alumina or any other insulating material or on the upper surface of the above-described piezoelectric substrate.

The first to Xth sets of ID electrodes may be formed on the piezoelectric substrate or in contact with the piezoelectric thin film. The method of forming the ID electrodes in contact with the piezoelectric thin film comprises a method of forming the first to Xth sets of ID electrodes over the piezoelectric thin film and a method of forming the first to Xth sets of ID electrodes between the substrate and the piezoelectric thin film.

The first to Xth sets of ID electrodes may be formed of a suitable electroconductive material, e.g., Al or an Al alloy. Each of the first to Xth sets of ID electrodes is formed of a pair of comb electrodes each having at least one electrode finger. The electrode fingers of the comb electrodes are arranged in an interlocking manner.

The first and second reflectors are provided to confine surface acoustic waves in the region between the first and second reflectors. Ordinarily, each of the first and second reflectors has a plurality of electrode fingers arranged perpendicularly to the surface wave propagation direction. The first and second reflectors may also be formed of a suitable electroconductive material. Preferably, they are formed of the same material as the first to third sets of ID electrodes e.g., Al or an Al alloy.

The longitudinal coupling type SAW resonator filter of the present invention is characterized by setting the center distances L_{S} and L_{A} to different values in the three-electrode-set type SAW resonator filter having first to Xth sets of ID electrodes and first and second reflectors arranged as described above. The selectivity of the filter can be improved by utilizing two resonant modes determined by the two center distances, as will be apparent from the following description of the embodiments of the present invention.

According to the present invention, if X = 3 and if each of the first and second reflectors has a plurality of electrode fingers arranged perpendicularly to the surface wave propagation direction, and if the wavelength of surface waves determined by the electrode pitch of the reflectors is I, the center distances L₁ and L₂ are set to such values that the center distance L₁ satisfies an inequality (1):${\text{0 + nλ < L}}_{\text{1}} \text{< 1/2λ + nλ}$ (n: an integer),
the center distance L₂ satisfies an inequality (2):${\text{1/2λ + mλ < L}}_{\text{2}} \text{< (m + 1)λ}$ (m: an integer), and
the center distance L₁ and the center distance L₂ satisfy an inequality (3):${\text{L}}_{\text{1}} {\text{≠ L}}_{\text{2}} \text{- 1/2λ + kλ}$ (k: an integer).

Thus, as will be apparent from the following description of the embodiments, a longitudinal coupling type SAW resonator filter capable of reliably setting the desired band width and having improved selectivity cab be provided.

Further, a longitudinal coupling type SAW resonator filter device comprising a substrate, and a plurality of longitudinal coupling type SAW resonator filters in accordance with the present invention may be provided. The plurality of longitudinal coupling type SAW resonator filters are formed on the substrate and connected in series to each other. That is, on one substrate, a plurality of longitudinal coupling type SAW resonator filters of the present invention may be formed and may be connected in series. In this manner, a filter having further improved selectivity can be provided.

The SAW resonator filter device may comprise a longitudinal coupling type SAW resonator filter in accordance with the present invention, and at least one of another longitudinal coupling type SAW resonator filter, a lateral coupling type SAW resonator filter and a trap using a SAW resonator formed on the substrate of the longitudinal coupling type SAW resonator filter of the present invention and electrically connected to the longitudinal coupling type SAW resonator filter of the present invention.

As described above, the SAW resonator filter device of the present invention may be electrically connected to any other SAW resonator filter, a trap and the like. Preferably, in such a case, other devices are constructed on the piezoelectric substrate constituting the SAW resonator filter device. In this manner, a smaller integrated SAW resonator filter device can be provided.

### BRIEF DESCRIPTION OF THE DRAWINGS

Fig. 1 is a plan view of the structure of a SAW resonator filter which represents an embodiment of the present invention;
Fig. 2 is a diagram showing a frequency characteristic of a conventional SAW resonator filter having the structure shown in Fig. 1 but having equal center distances L₁ and L₂ and having the number of electrode fingers of the reflectors set to zero;
Fig. 3 is a diagram showing a center distance L = L₁ = L₂ and relative resonance frequencies in the SAW resonator filter having the structure shown in Fig. 1;
Fig. 4 is a diagram for explaining the principle of operation of a SAW resonator filter having the electrode structure shown in Fig. 1 and arranged in accordance with the embodiment of the present invention;
Fig. 5 is a diagram showing an insertion loss-frequency characteristic of a SAW resonator filter device shown in Fig. 11A as a second embodiment of the present invention;
Fig. 6 is a diagram showing an insertion loss-frequency characteristic of the SAW resonator filter device shown in Fig. 11A when a thinning-out and weighting method is used;
Fig. 7 is a diagram showing an example of an insertion loss-frequency characteristic of a conventional SAW resonator filter;
Figs. 8A and 8B are schematic plan views of a portion where ID electrodes are formed, showing cases where the center distance is apparently changed when an electrode finger is added;
Figs. 9A and 9B are schematic plan views of a portion where ID electrodes are formed, showing cases where the center distance is apparently changed when one of the electrode fingersis removed;
Fig. 10 is a schematic plan view of a case where the adjacent-end electrode fingers of an adjacent pair of ID electrode sets are connected by the electrode material;
Figs. 11A are 11B are plan views of SAW resonator filter devices which represents second and third embodiments of the present invention; and
Fig. 12 is a plan view of a SAW resonator filter device which represents a fourth embodiment of the present invention.

### DESCRIPTION OF THE PREFERRED EMBODIMENTS

The present invention will be described below in detail with respect to preferred embodiments thereof.

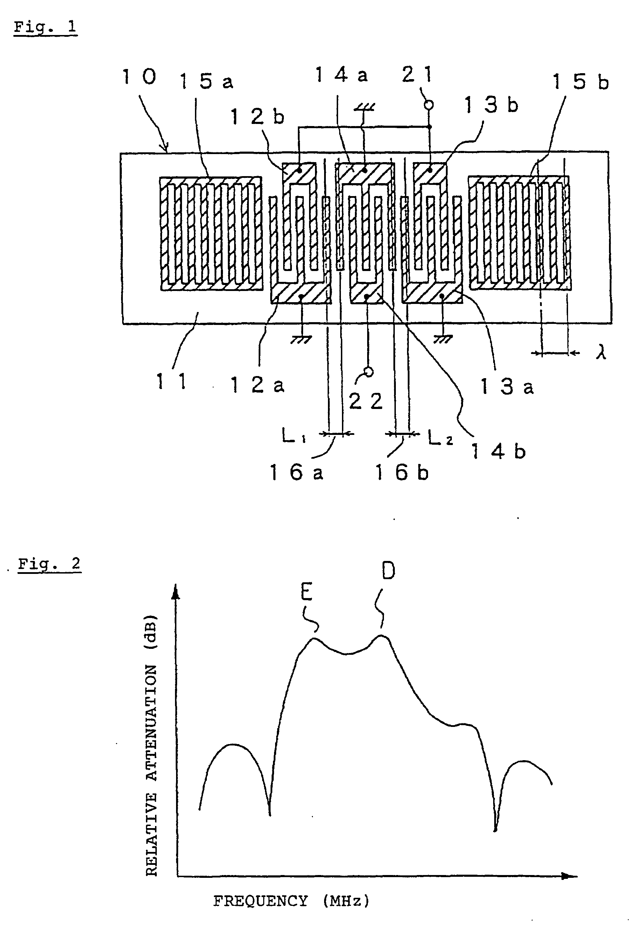

Referring to Fig. 1, a SAW resonator filter 10 which represents an embodiment of the present invention is constructed on a piezoelectric substrate 11 having a rectangular planar shape. In this embodiment, the piezoelectric substrate 11 is formed of 36° Y-cut X-propagation LiTaO₃.

A pair of comb electrodes 14a and 14b forming a first set of ID electrodes are formed on a central portion of the piezoelectric substrate 11. The comb electrode 14a is connected to ground while the comb electrode 14b is connected to an input/output terminal 22. The comb electrodes 14a and 14b have electrode fingers arranged in an interlocking manner.

Second and third sets of ID electrodes are formed on the opposite sides in the surface wave propagation direction of the first ID electrode set formed of the comb electrodes 14a and 14b. The second ID electrode set is formed of comb electrodes 12a and 12b while the third ID electrode set is formed of comb electrodes 13a and 13b.

Each of the pair of comb electrodes 12a and 12b and the pair of comb electrodes 13a and 13b have electrode fingers arranged in an interlocking manner, as do the comb electrodes 14a and 14b. However, the comb electrodes 12b and 13b having a smaller number of electrode fingers are disposed on the same side as the comb electrode 14a of the first ID electrode set having a larger number of electrode fingers.

The comb electrodes 12b and 13b are connected in common to an input/output terminal 21 while the comb electrodes 12a and 13a are connected to ground.

Reflectors 15a and 15b are formed on the opposite sides in the surface wave propagation direction of the area in which the first to third ID electrode sets are formed. Each of the reflectors 15a and 15b has electrode fingers arranged at equal pitches and each extending in the direction perpendicular to the surface wave propagation direction.

The above-described comb electrodes 12a, 12b, 13a, 13b, 14a, and 14b and the reflectors 15a and 15b are formed by forming an Al or Al alloy film over the piezoelectric substrate 11 and processing this film by photolithography and etching.

The features of this embodiment reside in that the value of the distance L₁ between the centers of the electrode fingers at the adjacent ends of the first and second ID electrode sets is within the range defined by the above-mentioned inequality (1), that the value of the distance L₂ between the centers of the electrode fingers at the adjacent ends of the first and third ID electrode sets is set so as to satisfy the above-mentioned inequality (2), and that the center distances L₁ and L₂ are set so as to satisfy the above-mentioned inequality (3). The symbol λ in the inequality (3) represents the wavelength determined by the electrode fingers pitch of the reflectors 15a and 15b (see Fig. 1).

In the SAW resonator filter of this embodiment, since the center distances L₁ and L₂ are set so as to satisfy the above-described conditions, the selectivity can be improved in comparison with the conventional SAW resonator filter. The principle of the operation and design conditions of the SAW resonator filter of this embodiment will next be described.

The principle of the operation of longitudinal coupling type SAW resonator filters generally used will first be described.

Conventional three-electrode-set longitudinal coupling type SAW resonator filters have generally the same structure as that of the SAW resonator filter shown in Fig. 1 as an embodiment of the present invention excepting the above-described relationship between the center distances L₁ and L₂. Therefore, the principle of the operation of conventional longitudinal coupling type SAW resonator filters will be described with reference to Fig. 1. In conventional three-electrode-set longitudinal coupling type SAW resonator filters, the distance L₁ between the centers of the electrode fingers at the adjacent ends of the first ID electrode set (comb electrodes 14a and 14b) and the second ID electrode set (comb electrodes 12a and 12b) and the distance L₂ between the centers of the electrode fingers at the adjacent ends of the first ID electrode set (comb electrodes 14a and 14b) and the third ID electrode set (comb electrodes 13a and 13b) are equal to each other. That is, L₁ = L₂ = L.

Fig. 2 shows a frequency characteristic in the case where the number of electrode fingers of the reflector electrodes in the conventional three-electrode-set longitudinal coupling type SAW resonator filter having equal center distances L₁ and L₂ is set to zero. A peak indicated by the arrow D in Fig. 2 is considered to be corresponding to a resonant mode due to multiple reflection between the first and second ID electrode sets or multiple reflection between the first and third electrode sets, and a peak indicated by the arrow E is considered to be corresponding to an internal resonant mode of the ID electrodes.

As conventional longitudinal coupling type resonator filters, longitudinal coupling type double mode filters have been realized by using the two resonant modes indicated by the arrows D and E. Longitudinal coupling type triple mode filters have also been realized by using these resonant modes and another resonant mode due to multiple reflection between the reflectors 15a and 15b at a frequency lower than the frequency of the resonant mode indicated by the arrow E in the case of adding the reflectors 15a and 15b.

Fig. 7 shows a typical characteristic of conventional longitudinal coupling type resonator filters in two-stage serial connection designed on the basis of the above-described principle. As described above, a filter having this structure has small loss but has unsatisfactory selectivity at frequencies higher than the pass band. That is, the attenuation in a frequency range higher than the center frequency by about + 20 to 30 MHz is at most 25 dB.

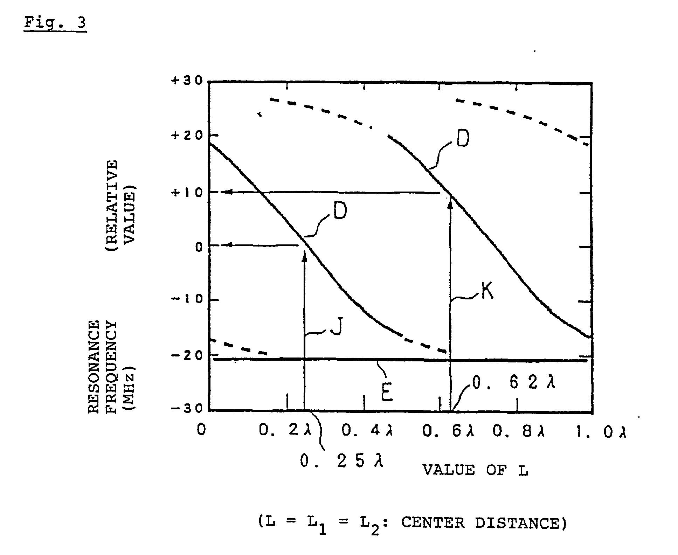

The resonance frequencies of the above-mentioned resonant modes D and E are determined by the value of the center distance L (= L₁ = L₂). Fig. 3 shows the relative positions of the resonant modes D and E with the center distance L used as a parameter. The characteristics shown in Fig. 3 are of a SAW filter arranged by setting the number of electrode fingers of the first ID electrode set, i.e., the sum of the numbers of electrode fingers of the comb electrodes 14a and 14b, to 57, the number of electrode fingers of the second ID electrode set (comb electrodes 12a and 12b) to 31, the number of electrode fingers of the third ID electrode set (comb electrodes 13a and 13b) to 31 and the number of electrode fingers of each of the reflectors 15a and 15b to 0, and by using a 36° Y-cut X-propagation LiTaO₃ substrate as piezoelectric substrate 11, the SAW filter having a center frequency of 866 MHz.

As can be understood from Fig. 3, the resonance frequency the resonant mode E is not dependent on the value of the center distance L, but the resonance frequency of the resonant mode D becomes lower as the value of L increases. When the center distance L becomes equal to about 0.45λ, a mode conversion from the resonant mode D into the resonant mode E starts. As the value of the center distance L increases further, the resonant mode D is completely converted into the resonant mode E and new resonant mode D appears from the high-frequency side.

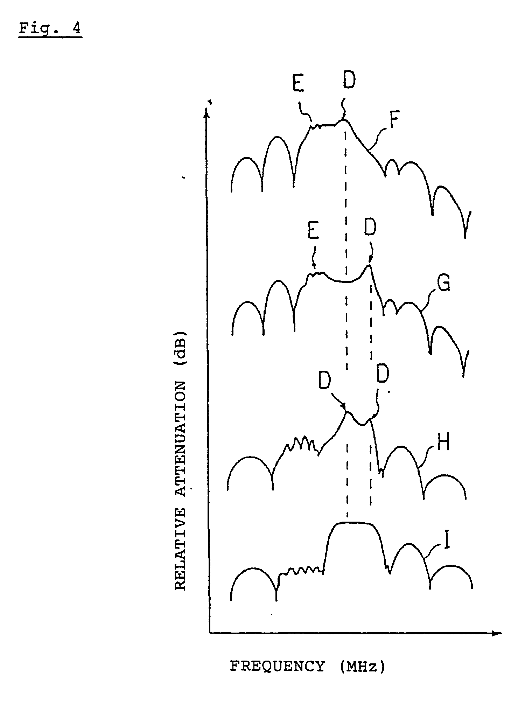

In contrast, in the above-described embodiment of the present invention, resonance is excited in two resonant modes D by setting the center distances L₁ and L₂ to different values, as explained below with reference to Fig. 4.

Fig. 4 shows the results of an experiment made by setting the number of electrode fingers of the first ID electrode set, i.e., the sum of the numbers of electrode fingers of the comb electrodes 14a and 14b, to 57, the number of electrode fingers of the second ID electrode set, i.e., the sum of the numbers of electrode fingers of the comb electrodes 12a and 12b, to 31, the number of electrode fingers of the third ID electrode set to 31, and the number of electrode fingers of each of the reflectors 15a and 15b to 150.

Characteristics F and G shown in Fig. 4 are shown for comparison with the embodiment of the present invention. Characteristic F was obtained by setting L₁ = L₂ = 0.25λ and characteristic G was obtained by setting L₁ = L₂ = 0.62λ. On the other hand, characteristic H shown in Fig. 4 was obtained by setting the distances L₁ and L₂ to different values: L = 0.25λ, and L2 = 0.62λ.

Two resonant modes occurred with respect to each of the characteristics F and G shown in Fig. 4. The peak at a higher frequency corresponds to the above-described resonant mode D while the peak at a lower frequency corresponds to the above-described resonant mode E. In the characteristics F and G shown in Fig. 4, the resonant mode E occurs at the end of the stop band of the reflector, so that the peak is rugged.

In contrast, in the characteristic H shown in Fig. 4, substantially no resonant mode E is recognized but two resonant modes D appear. The resonant mode D of a higher frequency occurs due to multiple reflection between the first ID electrode set (comb electrodes 14a and 14b) and the third ID electrode set (comb electrodes 13a and 13b) determined by the center distance L₂ while the resonant mode D of a lower frequency occurs due to multiple reflection between the first ID electrode set (comb electrodes 14a and 14b) and the second ID electrode set (comb electrodes 12a and 12b) determined by the center distance L₁.

Also, a double mode filter having a favorable characteristic such as indicated by I in Fig. 4 can be provided by adjusting the electrode interlocking width of the first to third electrode sets and/or by adding an external matching circuit.

The band width of SAW resonator filters having characteristics such as indicated by H and I in Fig. 4 is determined by the difference between the values of the center distances L₁ and L₂ and can be freely selected by adjusting these distances, as described below with reference to Fig. 3.

For example, center distance L₁ = 0.25λ is selected to set a reference resonance frequency (0 MHz in terms of relative value, indicated by the arrow J in Fig. 3), at which resonant mode D occurs between the comb electrodes 12a and 12b and the comb electrodes 14a and 14b. With respect to this frequency, if L₂ = 0.62λ is selected, resonant mode D occurs between the comb electrodes 13a and 13b and the comb electrodes 14a and 14b at a frequency higher by 10 MHz as indicated by arrow K in Fig. 3. By using these two resonant modes D, a band filter having a band width of 10 MHz in the band from 800 to 900 MHz can be obtained.

To increase the band width, the center distance L₁ may be set to a value larger than the above-mentioned value or the center distance L₂ may be set to a value smaller than the above-mentioned value. Conversely, to reduce the band width, the center distance L₁ may be reduced or the center distance L₂ may be increased. Under the characteristic conditions shown in Fig. 3, it is theoretically possible to realize a filter having a band width of 40 MHz at the maximum.

With respect to the conditions shown in Fig. 3, a similar filer may be arranged by selecting center distance L₁ = 0.12λ and center distance L₂ = 0.25λ. In this filter, however, resonant mode D corresponding to the center distance of 0.12λ and resonant mode D corresponding to the center distance of 0.25λ do not couple with each other because of the phase relationship therebetween. This filter is obtained as a double mode filter in which resonant mode D corresponding to the center distance of 0.25λ and resonant mode E couple with each other.

Accordingly, with respect to wavelength λ, it is necessary to select center distances L₁ and L₂ so as to satisfy the above-mentioned inequalities (1) and (2).${\text{L}}_{\text{1}} {\text{= L}}_{\text{2}} \text{-1/2λ + kλ}$ (k: integer)

If equation (11) is satisfied, the difference between two resonant modes D is zero and the phase difference therebetween is 180°, so that a double mode filter cannot be formed. Therefore, it is necessary to determine center distances L₁ and L₂ to such values as to satisfy inequalities (1) to (3).

The relationship between center distances L₁ and L₂ determines a certain phase. Therefore, if one of the electrode fingers of the comb electrodes at the outer ends in the surface wave propagation direction is removed or if an electrode finger is added, it is necessary to determine the relationship between center distances L₁ and L₂ by considering the phase determined by the relationship between center distances L₁ and L₂.

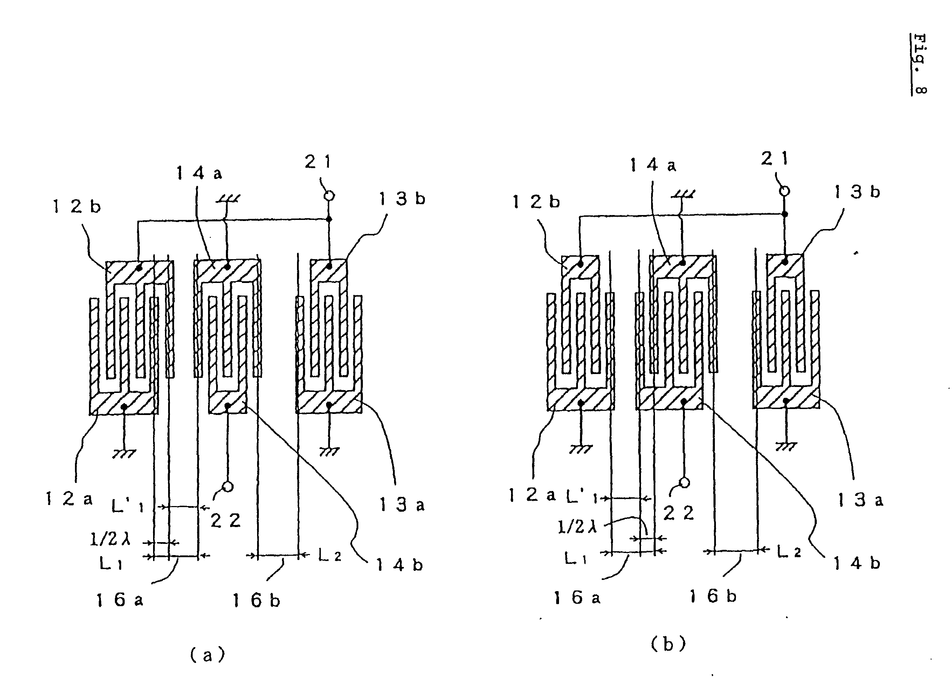

If the structure shown in Fig. 1 is changed by increasing the number of electrode fingers of the comb electrode 12b by one, as shown in Fig. 8A, or by increasing the number of electrode fingers of the comb electrode 14b by one, as shown in Fig. 8B, the center distance is apparently changed to L'₁ (= L₁ - 1/2λ). In such cases, however, the phase relationship of surface waves is not changed, so that there is no change in the resulting filter characteristic.

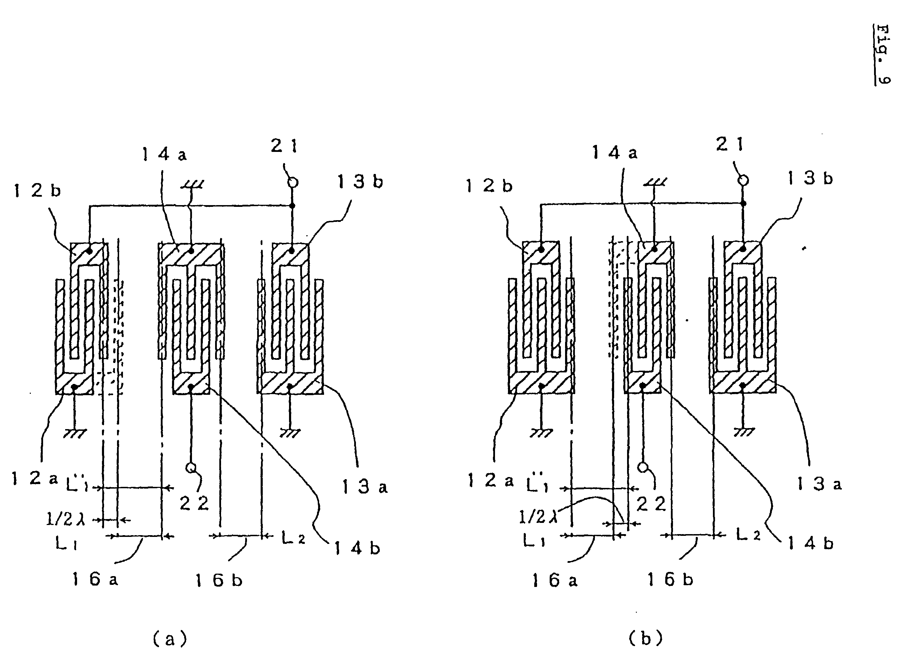

Fig. 9A shows an arrangement of removing one of the electrode fingers of the comb electrode 12a in the structure shown in Fig. 1, and Fig. 9B shows an arrangement of removing one of the electrode fingers of the comb electrode 14a in the same structure. In these arrangements, center distance L"₁ = (L₁ + 1/2λ). However, there is no change in the resulting filter characteristic.

The cases where the center distance L₁ is apparently changed have been described with reference to Figs. 8 and 9. However, the same description can be made with respect to center distance L₂. That is, each of center distances L₁ and L₂ is set as the distance between the centers of the adjacent-end electrode fingers both of which are connected to ground, or one of which is connected to an input end while the other of which is connected to an output end.

While the center distances satisfy the conditions represented by the above-described equations (1) to (3), an electrical connection may be established between the electrode fingers of the comb electrode 12a and the comb electrode 14a at the adjacent ends of these electrodes and/or between the adjacent electrode fingers of the comb electrode 13a and the comb electrode 14a by using the same electroconductive material as the material of the comb electrodes. Fig. 10 shows an example of a structure in which the adjacent electrode fingers of the comb electrode 12a and 14a are connected to each other.

In the structure shown in Fig. 10, the gap between electrode fingers of the comb electrodes 12a and 14a at the adjacent ends of these electrodes is filled with an electrode material 17 which is the same electroconductive material as that of the comb electrodes.

As is apparent from Figs. 8A, 8B, 9A, 9B and Fig. 10, it is necessary to determine center distances L₁ and L₂ of the present invention so as to maintain the same relationship between the phase of surface waves in the first ID electrode set and the phases of surface waves in the second and third ID electrode sets.

The SAW resonator filter of the present invention will be described with respect to experimental examples thereof.

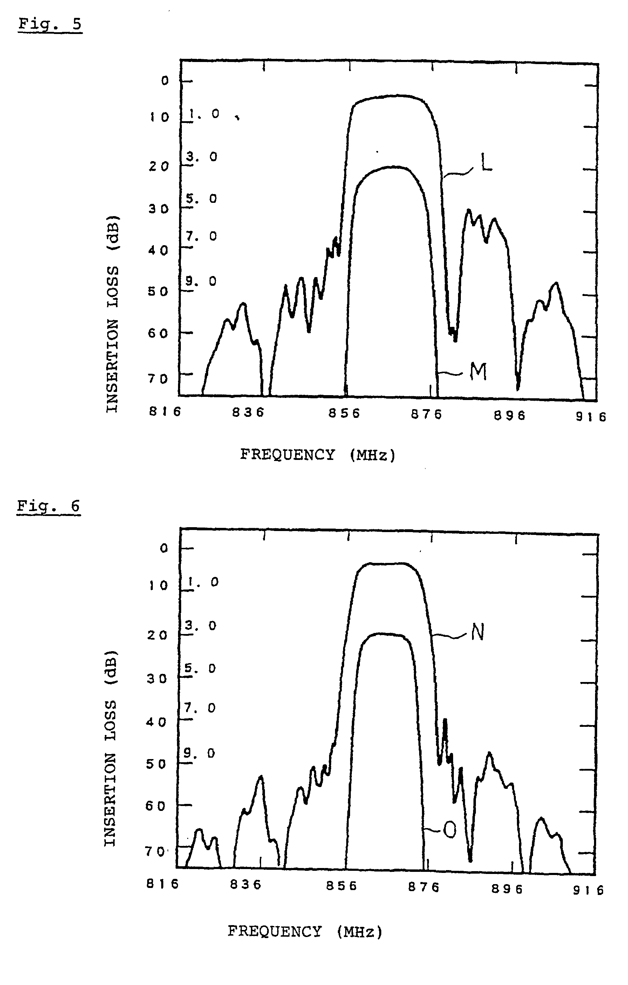

Fig. 5 shows an example of a characteristic of an RF filter arranged for use in a cordless telephone set of the CT-2 system in accordance with the present invention and having a center frequency of 866 MHz.

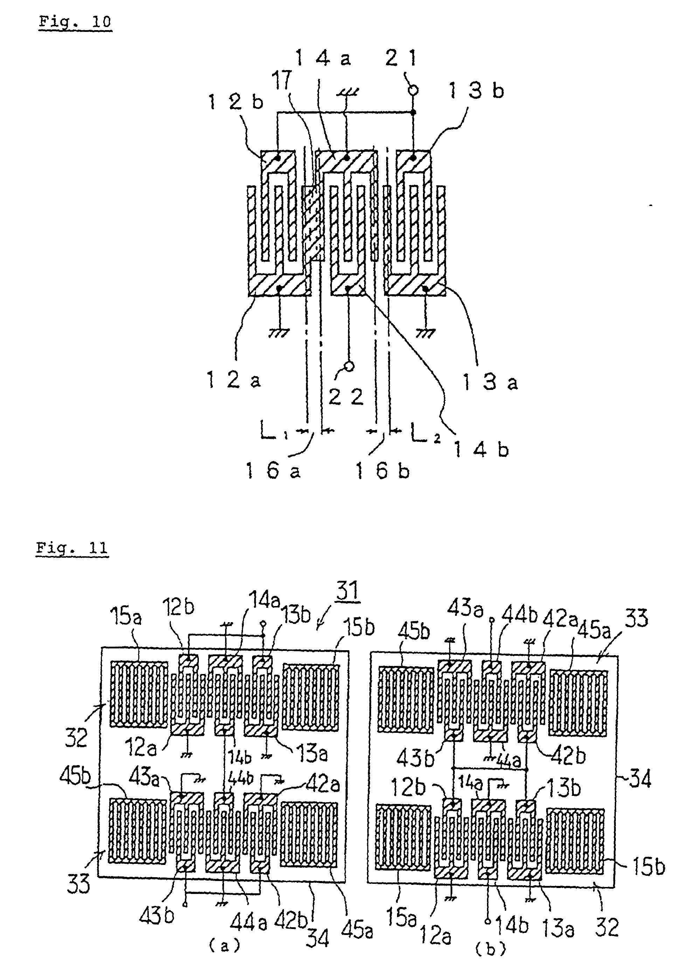

The filter having the characteristic shown in Fig. 5 is designed as a two-stage longitudinal coupling type SAW resonator filter device 31 shown in Fig. 11A. As shown in Fig. 11A, SAW resonator filters 32 and 33 are constructed on a rectangular piezoelectric substrate 34. The SAW resonator filter 32 has the same electrode structure as the SAW resonator filter 10 shown in Fig. 1. Therefore, the ID electrodes and reflectors corresponding to those shown in Fig. 1 are indicated by the same reference characters and the detailed description for them will not be repeated.

The SAW resonator filter 33 also has the same electrode structure as the SAW resonator filter 32. Therefore, the electrodes of the SAW resonator filter 33 are indicated by adding 30 to each of the numbers designating the electrodes of the SAW resonator filter 32, and the description for them will not be repeated.

As shown in Fig. 11A, the comb electrode 14b of the SAW resonator filter 32 is connected to the comb electrode 44b of the SAW resonator filter 33, thereby connecting the SAW resonator filters 32 and 33 in series.

More specifically, each of the SAW resonator filters 32 and 33 was constructed by setting the film thickness of the electrode members made of Al and forming the comb electrodes and the reflectors to 3.6 % of λ which is the wavelength of surface waves, by setting the numbers of electrode fingers of the first to third ID electrode sets to 65, 37 and 37, respectively, by setting the numbers of electrode fingers of reflectors 15a, 15b, 45a, and 45b to 150, by setting center distance L₁ = 0.30λ and center distance L₂ = 0.64λ, and by using 36° Y-cut X-propagation LiTaO₃ for piezoelectric substrate 34.

In the two-stage longitudinal coupling type SAW resonator filter device 31, as can be read from Fig. 5, a -4 dB band width of about 13 MHz, i.e., 1.5 % in terms of relative band width was obtained and improved selectivity was achieved in a frequency range in the vicinity of the pass band. Also, at the point of 866 MHz + 20 MHz where a strong demand for a sufficiently large attenuation should be satisfied, a large attenuation of 30 dB was achieved.

The characteristic curve M shown in Fig. 5 represents an essential portion of the characteristic indicated by L, which is replotted by enlarging the insertion loss on the ordinate, that is, by using the scale on the right-hand side of the ordinate to represent the insertion loss.

Fig. 6 shows a characteristic improved by combining the well-known thinning-out and weighting method with the arrangement of the above-described SAW resonator filter device 31. The characteristic curve O represents an essential portion of the characteristic curve N with the insertion loss on the ordinate enlarged. As can be understood from Fig. 6, the attenuation in the stop band in the vicinity of the pass band could be further improved by combining the thinning-out and weighting method, and a large attenuation of 45 dB or more was achieved at the point of 866 MHz + 20 MHz.

As is apparent from the characteristics shown in Figs. 5 and 6, the present invention can be utilized to improve the attenuation in the stop band higher than the pass band while the electrode fingers are still formed as solid electrodes, so that there is no need for manufacturing a split electrode structure requiring advanced processing techniques with respect to high frequencies. It is therefore possible to achieve adaptation for operation at higher radio frequencies without reducing the productivity.

While the SAW resonator filters 32 and 33 in the arrangement shown in Fig. 11A are connected in the above-described manner, comb electrodes 12b and 13b of the SAW resonator filter 32 may be connected to comb electrodes 43b and 42b of the SAW resonator filter 33 as shown in Fig. 11B.

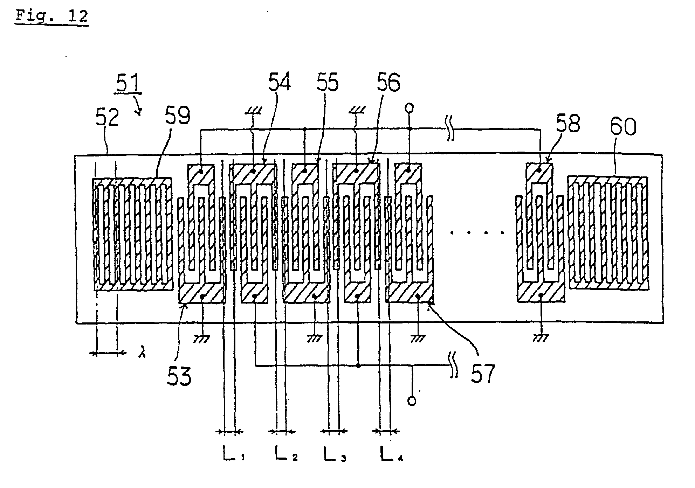

Fig. 12 is a schematic plan view of a longitudinal coupling type SAW resonator filter which represents a fourth embodiment of the present invention. As the first to third embodiments of the present invention, examples of application of the present invention to a longitudinal coupling type SAW resonator filters having three sets of ID electrodes have been described. However, the present invention can also be applied to a multiple electrode set type SAW resonator filter, such as that shown in Fig. 12, having four or more sets of ID electrodes.

That is, in a SAW resonator filter 51 shown in Fig. 12, a plurality of sets of ID electrode sets 53 to 58 are arranged in the surface wave propagation direction, and reflectors 59 and 60 are disposed on the opposite sides in the surface wave propagation direction of the area in which the ID electrode sets 53 to 58 are formed. As materials for forming a piezoelectric substrate 52, ID electrodes 53 to 58 and reflectors 59 and 60, the same materials as those in the SAW resonator filters of the first to third embodiments can be used.

In the longitudinal coupling type SAW resonator filter 51 having more than four sets of ID electrodes 53 to 58 formed in this manner, the ID electrodes and reflectors are formed so as to satisfy equations (4) and (5) and inequalities (6) to (10) shown below, thereby achieving the same advantages as those of the longitudinal coupling type SAW resonator filters of the first to third embodiments.

That is, ID electrode sets 53 to 58 are formed so that the distance between the centers of the adjacent-end electrode fingers of each adjacent pair of the ID electrode sets is selected so as to satisfy the following equations:${\text{L}}_{\text{S}} {\text{= L}}_{\text{1}} {\text{= L}}_{\text{3}} {\text{= L}}_{\text{5}} \text{...}$${\text{L}}_{\text{A}} {\text{= L}}_{\text{2}} {\text{= L}}_{\text{4}} {\text{= L}}_{\text{6}} \text{...}$ Also, if the wavelength of surface waves determined by the electrode finger pitch of reflectors 59 and 60 is λ, the center distances L_{S} and L_{A} are selected so as to satisfy the following inequalities:${\text{0 + nλ < L}}_{\text{S}} \text{< 1/2λ + nλ}$ (n: integer)${\text{1/2λ + mλ < L}}_{\text{A}} \text{< (m + 1)λ}$ (m: integer)
or the following inequalities:${\text{1/2λ + nλ < L}}_{\text{S}} \text{< (n + 1)λ}$ (n: integer)${\text{0 + mλ < L}}_{\text{A}} \text{< 1/2λ + mλ}$ (m: integer)

Further, the center distances L_{S} and L_{A} are selected so as to satisfy the following inequality:${\text{L}}_{\text{S}} {\text{≠ L}}_{\text{A}} \text{- 1/2λ + kλ}$ (k: integer)

According to the present invention, in the longitudinal coupling type SAW resonator filter using the first to third sets of ID electrodes, the center distances L₁ and L₂ are set to different values. This makes it possible to provide a double-mode longitudinal coupling type SAW resonator filter using two resonant modes determined by the center distances L₁ and L₂ and having improved selectivity.

That is, in the conventional longitudinal coupling type resonator filter, the attenuation in a stop band higher than the pass band is not sufficiently large because of a response of ID electrodes in the stop band. In contrast, in the above-described new double-mode longitudinal coupling type SAW resonator filter, the center distances L₁ and L₂ are set to different values, and two resonant modes determined by these center distances are excited, thereby effectively improving the attenuation in the stop band higher than the bass band.

According to the present invention, only setting the center distances L₁ and L₂ between the electrode fingers to different values may suffice, as described above, and there is no need for advanced processing techniques. Therefore, the same productivity as that of the conventional SAW resonator filter can be maintained. If the well-known electrode thinning-out and weighting method is also used, further improved selectivity can be achieved.

Further, a longitudinal coupling type SAW resonator filter having four or more sets of ID electrodes may be constructed, as shown in Fig. 12, as well as the longitudinal coupling type SAW resonator filter having three sets of ID electrodes. Also in such a case, the same advantages as those of the examples of the present invention set forth in Claims 1 and 2 can be achieved by setting the center distances as set forth in Claim 3.

A plurality of SAW resonator filters of the present invention may be connected in series on one piezoelectric substrate or the SAW resonator filter of the present invention may be connected to a different SAW element such as a SAW resonator filter or a trap on one substrate. In this manner, longitudinal coupling type SAW resonator filters adapted for various kinds of use can be provided as integrated devices. Also in such cases, the longitudinal coupling type SAW resonator filter of the present invention can operate with sufficiently high selectivity no matter what the connection arrangement.

## Claims

1. A longitudinal coupling type surface acoustic wave resonator filter (10, 32, 33, 51) comprising:
one of a substrate (11, 34, 52) made of a piezoelectric material and a substrate having a piezoelectric thin film formed thereon;
first to Xth (X: an integer equal to or larger than 3) sets of interdigital electrodes (12a, 12b, 13a, 13b, 14a, 14b, 42a, 42b, 43a, 43b, 44a, 44b, 53 - 58) formed on a piezoelectric surface of said substrate;
said second to Xth sets of interdigital electrodes (12a, 12b, 13a, 13b, 42a, 42b, 43a, 43b) being formed along a direction of propagation of surface wave excited or received by said first set of interdigital electrodes (14a, 14b, 44a, 44b);
first and second reflectors (15a, 15b, 45a, 45b, 59, 60) formed on the opposite sides in the surface wave propagation direction of the area in which said first to Xth sets of interdigital electrodes are provided; and
each of said sets of interdigital electrodes being formed of a pair of comb-shaped electrodes each having at least one electrode finger,
**characterised in that**
the center distances between adjacent electrode fingers of adjacent pairs of said interdigital electrodes are L₁, L₂,....Lₓ₋₁, the center distances satisfy equations (1) and (2):${\text{L}}_{\text{s}} {\text{=L}}_{\text{1}} {\text{=L}}_{\text{3}} {\text{=L}}_{\text{5}} \text{........}$${\text{L}}_{\text{A}} {\text{=L}}_{\text{2}} {\text{=L}}_{\text{4}} {\text{=L}}_{\text{6}} \text{.....}$ wherein the wavelength of surface waves determined by the electrode finger pitch of said reflectors is λ, said center distances L_{S} and L_{A} satisfy inequalities (3) and (4)${\text{0 + nλ < L}}_{\text{s}} \text{< λ/2 + nλ}$ (n: an integer)${\text{λ/2 + mλ < L}}_{\text{A}} \text{< (m+1)λ}$ (m: an integer)
or inequalities (5) and (6):${\text{λ/2 + nλ < L}}_{\text{S}} \text{< (n+1)λ}$ (n: an integer)${\text{0 + mλ < L}}_{\text{A}} \text{< λ/2 + mλ}$ (m: an integer),
and
the distances L_{S} and L_{A} satisfy an inequality (7):${\text{L}}_{\text{S}} {\text{≠ L}}_{\text{A}} \text{- λ/2 + kλ}$ (k: an integer).

2. A longitudinal coupling type surface acoustic wave resonator filter (10, 32, 33), according to claim 1, wherein the X is three.

3. A longitudinal coupling type surface acoustic wave resonator filter (51), according to claim 1, wherein the X is four or more.

4. A surface acoustic wave resonator filter device comprising:
a longitudinal coupling type surface acoustic wave resonator filter according to any one of claims 1 to 3; and
at least one of a longitudinal coupling type surface acoustic wave resonator filter, a lateral coupling surface acoustic wave resonator filter and a trap using a surface acoustic wave resonator formed on the substrate of said longitudinal coupling type surface acoustic wave resonator filter according to any one of claims 1 to 3 and electrically connected to said longitudinal coupling type surface acoustic wave resonator filter according to any one of claims 1 to 3.

## Patentansprüche

1. Akustisches Oberflächenwellenresonatorfilter mit longitudinaler Kopplung (10, 32, 33, 51), welches umfaßt:
eines der Substrate (11, 34, 52) aus piezoelektrischem Material und ein Substrat, auf welchem ein piezoelektrischer Dünnfilm ausgebildet ist,
erste bis Xte (X: eine ganze Zahl, die gleich 3 oder größer ist) Sätze von auf einer piezoelektrischen Oberfläche des genannten Substrats ausgebildeten Interdigital-Elektroden (12a, 12b, 13a, 13b, 14a, 14b, 42a, 42b, 43a, 43b, 44a, 44b, 53 - 58),
wobei die genannten zweiten bis Xten Sätze von Interdigital-Elektroden (12a, 12b, 13a, 13b, 42a, 42b, 43a, 43b) entlang einer Ausbreitungsrichtung einer Oberflächenwelle ausgebildet werden, welche von dem genannten ersten Satz von Interdigital-Elektroden (14a, 14b, 44a, 44b) erzeugt oder empfangen wird,
erste und zweite Reflektoren (15a, 15b, 45a, 45b, 59, 60), welche auf den gegenüberliegenden Seiten in der Oberflächenwellen-Ausbreitungsrichtung des Bereichs ausgebildet werden, in welchem die genannten ersten bis Xten Sätze von Interdigital-Elektroden liegen und
wobei jeder der genannten Sätze von Interdigital-Elektroden aus einem Paar kammförmiger Elektroden besteht, die jeweils wenigstens einen Elektrodenfinger aufweisen,
**dadurch gekennzeichnet, daß**
die Mittenabstände zwischen benachbarten Elektrodenfingern von benachbarten Paaren der genannten Interdigital-Elektroden L₁, L₂,....Lₓ₋₁ sind, die Mittenabstände die Gleichungen (1) und (2) erfüllen:${\text{L}}_{\text{S}} {\text{=L}}_{\text{1}} {\text{=L}}_{\text{3}} {\text{-L}}_{\text{5}} \text{......}$${\text{L}}_{\text{A}} {\text{=L}}_{\text{2}} {\text{=L}}_{\text{4}} {\text{=L}}_{\text{6}} \text{......}$ worin die durch die Elektrodenfingerteilung der genannten Reflektoren bestimmte Oberflächenwellenlänge 1 beträgt und die genannten Mittenabstände L_{S} und L_{A} die Ungleichheiten (3) und (4) erfüllen${\text{0 + nλ < L}}_{\text{S}} \text{< λ/2 + nλ}$ (n: eine ganze Zahl)${\text{λ/2 + mλ < L}}_{\text{A}} \text{< (m+1)λ}$ (m: eine ganze Zahl)
oder die Ungleichheiten (5) und (6):${\text{λ/2 + nλ < L}}_{\text{S}} \text{< (n+1)λ}$ (n: eine ganze Zahl)${\text{0 + mλ < L}}_{\text{A}} \text{< λ/2 + mλ}$ (m: eine ganze Zahl)
und
die Abstände L_{S} und L_{A} eine Ungleichheit (7) erfüllen:${\text{L}}_{\text{S}} {\text{≠ L}}_{\text{A}} \text{- λ/2 + kλ}$ (k: eine ganze Zahl).

2. Akustisches Oberflächenwellenresonatorfilter mit longitudinaler Kopplung (10, 32, 33) nach Anspruch 1, **dadurch gekennzeichnet, daß** X gleich drei ist.

3. Akustisches Oberflächenwellenresonatorfilter mit longitudinaler Kopplung (51) nach Anspruch 1, **dadurch gekennzeichnet, daß** X gleich vier oder mehr ist.

4. Akustische Oberflächenwellenresonatorfiltervorrichtung, **dadurch gekennzeichnet, daß** sie umfaßt:
ein akustisches Oberflächenwellenresonatorfilter mit longitudinaler Kopplung nach einem der Ansprüche 1 bis 3 und
wenigstens eines der folgenden Elemente: ein akustisches Oberflächenwellenresonatorfilter mit longitudinaler Kopplung, ein akustisches Oberflächenwellenresonatorfilter mit lateraler Kopplung und eine Fangstelle unter Verwendung eines akustischen Oberflächenwellenresonators, welcher auf dem Substrat des genannten akustischen Oberflächenwellenresonatorfilters mit longitudinaler Kopplung nach einem der Ansprüche 1 bis 3 ausgebildet und elektrisch mit dem genannten akustischen Oberflächenwellenresonatorfilter mit longitudinaler Kopplung nach einem der Ansprüche 1 bis 3 verbunden ist.

## Revendications

1. Filtre résonateur à ondes acoustiques de surface du type à couplage longitudinal (10, 32, 33, 51) comprenant:
l'un d'un substrat (11, 34, 52) réalisé en un matériau piézo-électrique et un substrat sur lequel est formé un film mince piézo-électrique ;
des premier à X-ième (X : entier égal ou supérieur à 3) ensembles d'électrodes interdigitées (12a, 12b, 13a, 13b, 14a, 14b, 42a, 42b, 43a, 43b, 44a, 44b, 53-58) formés sur une surface piézo-électrique dudit substrat ;
lesdits second à X-ième ensembles d'électrodes interdigitées (12a, 12b, 13a, 13b, 42a, 42b, 43a, 43b) étant formés selon une direction de propagation de l'onde de surface excitée ou reçue par ledit premier ensemble d'électrodes interdigitées (14a, 14b, 44a, 44b) ;
des premier et second réflecteurs (15a, 15b, 45a, 45b, 59, 60) formés sur les côtés opposés dans la direction de propagation de l'onde de surface de la zone dans laquelle sont prévus lesdits premier à X-ième ensembles d'électrodes interdigitées ; et
chacun desdits ensembles d'électrodes interdigitées étant formé d'une paire d'électrodes en forme de peigne ayant chacune au moins un doigt d'électrode,
**caractérisé en ce que**
les distances centrales entre des doigts d'électrode adjacents de paires adjacentes desdites électrodes interdigitées sont L₁, L₂,... Lₓ₋₁, les distances centrales satisfont aux équations (1) et (2) :${\text{L}}_{\text{S}} {\text{= L}}_{\text{1}} {\text{= L}}_{\text{3}} {\text{= L}}_{\text{5}} \text{...}$${\text{L}}_{\text{A}} {\text{= L}}_{\text{2}} {\text{= L}}_{\text{4}} {\text{= L}}_{\text{6}} \text{...}$ dans lequel la longueur d'onde d'ondes de surface déterminée par le pas de doigts d'électrode desdits réflecteurs est λ, lesdites distances centrales L_{S} et L_{A} satisfont aux inégalités (3) et (4)${\text{0 + nλ < L}}_{\text{S}} \text{< λ/2 + nλ}$ (n : entier)${\text{λ/2 + mλ < L}}_{\text{A}} \text{< (m+1)λ}$ (m : entier)
ou aux inégalités (5) et (6) :${\text{λ/2 + nλ < L}}_{\text{S}} \text{< (n+1)λ}$ (n : entier)${\text{0 + mλ < L}}_{\text{A}} \text{< λ/2 + mλ}$ (m : entier)
et les distances L_{S} et L_{A} satisfont à l'inégalité (7) :${\text{L}}_{\text{S}} {\text{≠ L}}_{\text{A}} \text{- λ/2 = kλ}$ (k : entier)

2. Filtre résonateur à ondes acoustiques de surface du type à couplage longitudinal (10, 32, 33) selon la revendication 1, dans lequel X est trois.

3. Filtre résonateur à ondes acoustiques de surface du type à couplage longitudinal (51) selon la revendication 1, dans lequel X est quatre ou plus.

4. Dispositif de Filtre résonateur à ondes acoustiques de surface comprenant :
un filtre résonateur à ondes acoustiques de surface du type à couplage longitudinal selon l'une quelconque des revendications 1 à 3 ; et
au moins l'un d'un filtre résonateur à ondes acoustiques de surface du type à couplage longitudinal, un filtre résonateur à ondes acoustiques de surface à couplage latéral et un piège utilisant un résonateur à ondes acoustiques de surface formé sur le substrat dudit filtre résonateur à ondes acoustiques de surface du type à couplage longitudinal selon l'une quelconque des revendications 1 à 3 et relié électriquement audit filtre résonateur à ondes acoustiques de surface du type à couplage longitudinal selon l'une quelconque des revendications 1 à 3.
